# EUROPEAN PATENT APPLICATION

(11) **EP 4 300 545 A1**
(43) Date of publication of application: **03.01.2024**
(21) Application number: 23182225.5
(22) Date of filing: 28.06.2023
(51) Int. Cl.: H01L 21/3065, H01J 37/32

(54) **CONTROL OF TRENCH PROFILE ANGLE IN SIC SEMICONDUCTORS**

(30) Priority: 01.07.2022 GB 202209674
(71) Applicant: SPTS Technologies Limited, Newport Gwent NP18 2TA (GB)
(72) Inventor: Ashraf, Huma, Newport (GB); Riddell, Kevin, Newport (GB); Croot, Alex, Newport (GB)
(74) Representative: Wynne-Jones IP Limited

(57) **Abstract**

A method of plasma etching silicon carbide semiconductor substrate and plasma etch apparatus for plasma etching a silicon carbide semiconductor substrate are provided.

## Description

This invention relates to a method of plasma etching a silicon carbide semiconductor substrate. This invention also relates to a plasma etching apparatus.

### Background

Silicon Carbide (SiC) is a wideband gap (3.28eV for 4H-SiC) semiconductor that can support very high breakdown voltages of approximately 2.2MV/cm, which is approximately seven times the breakdown voltage of pure Silicon with greater than twice the thermal conductivity of pure Silicon. SiC is widely used in high power, high frequency applications such as battery chargers for electric vehicles, inverters and energy storage and transmission due to the thermal and frequency benefits over established Si IGBT (insulated-gate bipolar transistor) technology.

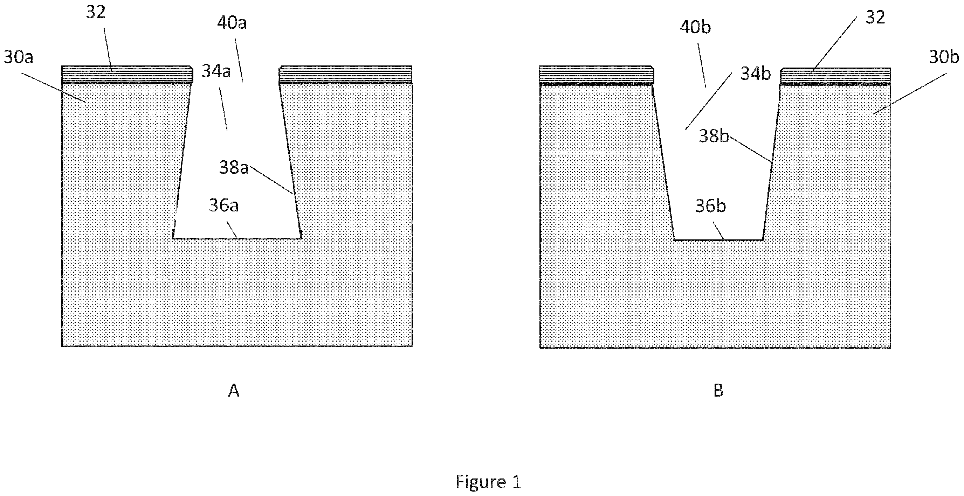

In order to fabricate SiC devices, MOSFETs, Schottky diodes or MEMS-based structures, the relatively inert SiC material needs to be patterned with a mask and is typically etched using an anisotropic plasma etch process. Masks can be either metallic, for example Ni, metal-based, such as ITO, or dielectric SiO₂ or SiN. As disclosed in US 2016/016385 A1, when etching trenches in the SiC surface, there is frequently the requirement to produce a well-defined taper in the range of 85-90° to the horizontal. The "positive" taper (less than 90°), as shown in Figure 1B, not only makes coating and filling the trench less demanding on subsequent processes such as PE-CVD, CVD or PVD deposition steps, but can also influence the electrical performance of the device by aligning the feature to crystal planes in the SiC matrix.

Dry etched silicon carbide trenches can be between 1 - 10 µm wide and between 1 - 10µm deep and can have a flat or rounded base post plasma etch. Post etch it is possible to round the base through the use of a high temperature H₂ annealing process.

Traditionally, Sulfur Hexafluoride (SF₆) is the main gas used to plasma etch SiC at high etch rates, with etch rates of between 600 and 1000 nm/min being achievable. Typically, SF₆ is combined with He or Ar, and O₂. The high powers and low pressures required both to break the strong bonds in SiC and to prevent "micro-trenching", the formation of secondary trenches at the trench base corner, can cause the side-wall profile of the etched trenches to have a "re-entrant" profile (i.e. a sidewall taper of greater than 90°), as shown in Figure 1A. This constrains the process window for the use of conventional fluorine-based etch chemistries.

Previous attempts have been made to overcome the drawbacks of fluorine-based etch chemistries. For example, "Low-damage etching of silicon carbide in Cl2-based plasmas" by F.A.Khan et al., Journal of The Electrochemical Society, 149 (7) G420-G423 (2002) attempted to etch vias in SiC substrates using etch mixtures of SF₆ with BCl₃ or HCl. However, the etch rates achievable with these etch mixtures were lower than standard SF₆ etch chemistries.

Therefore, there is a need in the art to provide an improved method of plasma etching a silicon carbide semiconductor to form a feature which enables fine tuning of the taper within the feature without a reduction in etch rate when compared to the established SiF₆/O₂ etch process.

### Statement of Invention

The present invention, in at least some of its embodiments, seeks to address the above described problems, desires and needs.

According to a first embodiment of the present invention there is provided a method of plasma etching a silicon carbide semiconductor substrate to form a feature, the method comprising the steps of:
- providing a substrate with a mask formed thereon on a substrate support in a chamber, the mask having an opening, wherein the substrate is formed from silicon carbide;
- performing a plasma etch step to anisotropically etch the substrate through the opening to produce a feature,
wherein the plasma etch step comprises generating a plasma from an etchant gas mixture comprising at least one fluorine-containing component and chlorine gas.

It has been found by the present inventors that the combination of at least one fluorine-containing component and chlorine gas in the etchant gas mixture allows for fine tuning of the taper of the feature without sacrificing other etch characteristics such as etch rate and selectivity.

The at least one fluorine-containing component can comprise SF₆, SiF₄ or a combination thereof. The at least one fluorine-containing component can comprise both SF₆ and SiF₄. The etchant gas mixture can further comprise SiCla.

The etchant gas mixture can further comprise an oxygen-containing component. The oxygen-containing component can comprise O₂, H₂O, N₂O and/or O₃. The oxygen-containing component can be O₂ gas.

The flow rate of each of the at least one fluorine containing component, chlorine gas and, when present, SiCl₄ and the oxygen-containing component can be at most 100 sccm. If SF₆ is present, the flow rate can be from 30 sccm to 60 sccm. If SiF₄ is present, the flow rate can be from 20 sccm to 98 sccm. If SiCl₄ is present, the flow rate can be from 5 sccm to 95 sccm. If present, the flow rate of the Oxygen-containing component can be from 5 sccm to 95 sccm, optionally from 50 sccm to 80 sccm.

The etchant gas mixture can further comprise an inert gas component. The inert gas component can be helium (He) or argon (Ar). The inert gas component can consist of argon. If present, the flow rate of the inert gas component can be at most 500 sccm. If present, the flow rate of the inert gas component can be at least 300 sccm.

The etchant gas mixture can consist of or consist essentially of at least one fluorine-containing component, chlorine gas, SiCl₄, an oxygen-containing component and an inert gas component. The etchant gas mixture can consist of or consist essentially of SF₆, SiF₄, chlorine gas, SiCl₄, O₂ and Ar.

The plasma etch step can comprise the step of altering a fluorine-containing components flow rate and a chlorine-containing components flow rate in order to change a fluorine-containing component: chlorine containing component ratio and thereby change the profile angle of the feature. The plasma etch step can comprise the step of setting a SF₆ flow rate and a Cl₂ flow rate and altering a SiF₄ flow rate and a SiCl₄ flow rate in order to change a fluorine-containing component: chlorine containing component ratio and thereby change the profile angle of the feature. The fluorine-containing component: chlorine containing component ratio can be kept constant during the duration of the plasma etch step. Alternatively, the fluorine-containing component: chlorine containing component ratio can be altered during the duration of the plasma etch step.

The plasma etch step can be performed using a plasma source that supplies a power of from 800 W to 2500 W to the plasma. The plasma source can supply a power of 2200 W to the plasma. An electrical power of from 700 W to 1400 W can applied to the substrate support during the plasma etch step. The electrical power applied to the substrate support during the plasma etch step can be about 1300 W. The electrical power applied to the substrate during the secondary etching process can be a RF bias power.

The substrate support can be maintained at a temperature of between 10 °C and 30 °C. The substrate support can be maintained at a temperature of about 20 °C. The chamber can be cooled to a temperature of 55 °C. The chamber can be cooled by water cooling.

The pressure within the chamber can be from 2 mTorr (0.267 Pa) to 20 mTorr (2.67 Pa). The pressure within the chamber can be about 10 mTorr (1.33 Pa).

The mask can be a hard mask, such as an inorganic dielectric mask. The mask can comprise a Silicon-containing component, such as SiO₂ or SiN. The mask can comprise SiO₂.

The plasma generated in the plasma etch step can be an inductively coupled plasma. The plasma etch step can be performed using an inductively coupled plasma (ICP) etch apparatus.

The substrate can be at least one layer of epitaxial silicon carbide deposited on a carrier wafer. The carrier wafer can be formed of silicon carbide.

According to a second embodiment of the present invention there is provided a plasma etch apparatus for plasma etching a substrate to form a feature using the method according to the first embodiment of the present invention, the apparatus comprising:
- a chamber;
- a substrate support disposed within the chamber for supporting a substrate thereon;
- at least one gas inlet for introducing a gas or gas mixture into the chamber at a flow rate;
- a plasma generating means for sustaining a plasma in the chamber;
- a power supply for supplying an electrical bias power to the substrate support; and
- a controller configured to operate the plasma etch apparatus to generate a plasma from an etchant gas mixture comprising at least one fluorine-containing component and chlorine gas.

The at least one gas inlet can comprise a first gas inlet for introducing at least one fluorine-containing component into the chamber and a second gas inlet for introducing chlorine gas into the chamber, and the controller can be configured to form an etchant gas mixture in the chamber comprising at least one fluorine-containing component and chlorine gas and generate a plasma from the etchant gas mixture.

The at least one gas inlet can comprise a third gas inlet for introducing SiF4 intro the chamber and a fourth gas inlet for introducing SiCl4 into the chamber, and the controller can be configured to form an etchant gas mixture in the chamber comprising the at least one fluorine-containing component that can comprise SiF4, chlorine gas and SiCl4 and generate a plasma from the etchant gas mixture.

The at least one gas inlet can comprise a fifth gas inlet for introducing an oxygen-containing component intro the chamber and a sixth gas inlet for introducing an inert gas component into the chamber, and the controller can configured to form an etchant gas mixture in the chamber comprising the at least one fluorine-containing component, chlorine gas, the oxygen-containing component and the inert gas component and generate a plasma from the etchant gas mixture.

Each of the first gas inlet to sixth gas inlet can be the same as at least one of the other gas inlets.

For the avoidance of doubt, whenever reference is made herein to 'comprising' or 'including' and like terms, the invention is also understood to include more limiting terms such as 'consisting' and 'consisting essentially'.

Whilst the invention has been described above, it extends to any inventive combination of the features set out above, or in the following description, drawings or claims. For example, any features disclosed in relation to the first embodiment of the invention can be combined with any features of the second embodiment of the invention and *vice versa.*

### Description of Figures

Aspects of methods and apparatuses in accordance with the invention will now be described with reference to the accompanying drawings, in which:
Figure 1 is a cross-sectional schematic view of a feature with a) a re-entrant taper and b) a positive taper;
Figure 2 is a plasma etch apparatus in accordance with a second embodiment of the present invention suitable for performing a method according to a first embodiment of the invention; and
Figure 3 is a flow chart showing a method according to a first embodiment of the invention.

### Detailed Description

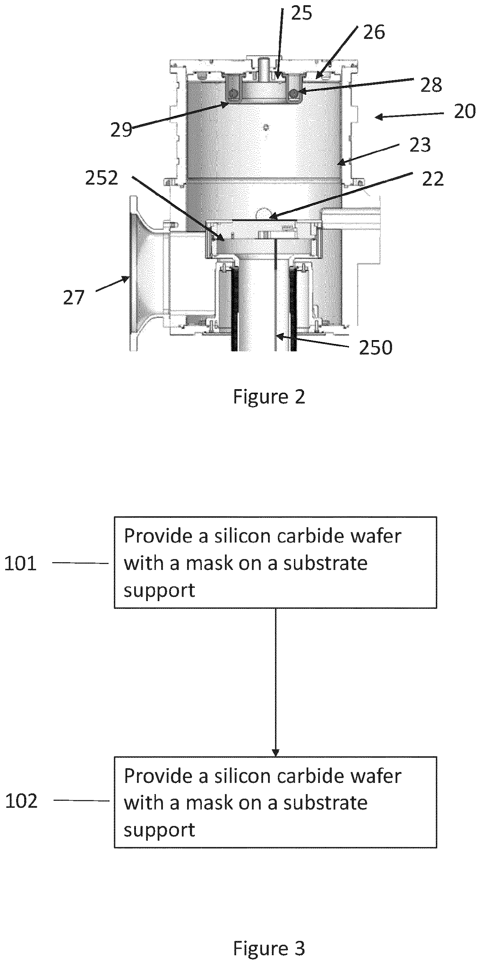

Figure 2 shows a schematic representation of a plasma etch apparatus 20 in accordance with the second embodiment of the invention suitable for performing methods according to the first embodiment of the present invention. Plasma etching of a substrate is performed using a suitable plasma etch apparatus. The plasma etch apparatus can be an inductively coupled plasma (ICP) apparatus. However, etching can also be performed using other plasma etch systems, such as helicon, RIE or microwave type apparatus. The operation of generating a plasma within such plasma etch apparatus is well-known in the art and will not be described here other than where necessary for an understanding of the present invention.

A plasma etching tool suitable for performing the method of the present invention is an Omega^{™} Synapse^{™} ICP etch system available from SPTS Technologies Limited of Newport, UK. A plasma etch apparatus 20 typically comprises a substrate support (or platen) 22, also known as a wafer support, disposed within a chamber 23 for supporting a substrate. A bias power can be supplied to the substrate by a RF power supply 250 via an impedance matching network (not shown) and an electrode 252. Typical RF frequencies for operation of the RF power supply can be between about 380 kHz and 13.56 MHz.. Process gases can be introduced into the chamber 23 via one or more gas inlets 25, 26. In one embodiment, at least six gas inlets 26 can be present. However, in the illustrated embodiment, two gas inlets 25, 26 are provided, and the gases from which the plasma is generated are introduced to the chamber 23 through the two gas inlets 25, 26. A plasma generating means 28, such as an inductive coil, can be used to generate and sustain a plasma within the chamber 23 as is known in the art (e.g. using a RF power supply and impedance matching network). In the illustrated embodiment, the plasma generating means is an RF inductive coil 28 contained within a housing 29. The gases can be removed from the chamber 23 via a pumping port 27. Also provided is a controller (not shown) which is configured to control the apparatus to perform the process sequence described herein.

An exemplary method according to a first embodiment of the present invention will be described in combination with Figures 1 and 3. In the exemplary method, a silicon carbide (SiC) semiconductor substrate 30 is etched to form a feature. In the exemplary method, the feature is a trench, and the substrate 30 is epitaxial silicon carbide in the form of a layer deposited on a 150 mm silicon carbide carrier wafer. In the exemplary method, the layer of epitaxial silicon carbide is approximately 1 µm thick. However, other features can be formed in the method of the first embodiment of the present invention. Other wafer sizes, for example from 75 mm to 200 mm, other thicknesses of epitaxial silicon carbide and different carrier wafers can also be used in the method of the first embodiment of the present invention. Although the parameters stated below are those used for the etching of a 1 µ thick layer of epitaxial SiC on a 150 mm SiC wafer, they can be varied with the size of the wafer in a manner known in the art. The substrate 30 includes a patterned mask layer 32, such as a silicon dioxide (SiO₂) layer or other suitable mask layer. The mask layer 32 is typically more resistant to the plasma etch conditions that the epitaxial silicon carbide layer.

In a first step 101, the substrate 30 to be etched is positioned on the substrate support 22 in a plasma etch apparatus 20 with the face to be etched facing upwards. A pre-etch can optionally be performed to prepare the substrate 30 prior to the plasma etch, for example to remove unwanted material from the open areas of the mask layer 32.

In a second step 102, a plasma etch step is performed to selectively etch the SiC substrate 30 so that the trench structure is formed. Numeral 34b represents the feature as illustrated in Figure 1B. The plasma etch step anisotropically etches the substrate 30 in the areas of the substrate 30 that are not covered by the mask layer 32. A bias power is applied to the platen 22 during the plasma etch step. For example, the bias power applied to the platen can be in the range of about 700 W to about 1400 W, optionally about 1300 W. This helps to impart a directionality to the species (e.g. ions) in the plasma so that the base 36b of the trench 34b is preferentially etched (rather than the sidewalls 38b of the trench).

The etch gas mixture used to generate the plasma consists of SF₆, Cl₂, SiF₄, SiCl₄, O₂ and Ar gases. The flow rate of each of SF₆, Cl₂, SiF₄, SiCl₄ and O₂ is at most 100 sccm. The SF₆ flow rate can be from 30 sccm to 60 sccm, the SiF₄ flow rate can be from 20 sccm to 98 sccm, the SiCl₄ flow rate can be from 5 sccm to 95 sccm and the O₂ flow rate can be from 5 sccm to 95 sccm, optionally from 50 sccm to 80 sccm. The Ar flow rate can be from 300 sccm to 500 sccm.

The present inventors have found that by controlling the F:Cl flow rate ratio, the resultant trench profile angle can be altered whilst maintaining the desired etch characteristics such as etch rate and selectivity. One of the most effective means of altering the resultant trench profile angle whilst maintaining the etch rate is by maintaining the flow rate of SF₆ and Cl₂ at a set value and altering the flow rate of SiF₄ and SiCl₄ as a means of altering the overall F:Cl ratio. By maintaining a minimum SF₆ and Cl₂ flow rate, the etch rate and selectivity of the plasma etch step is maintained, but the alteration of the SiF₄ and SiCl₄ flow rates can fine-tune the resultant trench profile angle. For example, lowering the SiCl₄ flow rate and raising the SiF₄ flow rate can increase the profile angle (increased towards 90°), whilst raising the SiCl₄ flow rate and lowering the SiF₄ flow rate can decrease the profile angle (reduced from 90°).

The ratio of F:Cl can be kept constant throughout the plasma etch step. Alternatively, the F:Cl ratio can be altered during the plasma etch step. Changing the F:Cl ratio can dynamically change the taper of the resultant trench, providing changes in taper as the etch progresses. This change in trench angle can reduce "field-bunching", where the electric field is susceptible to concentrating at a particular location within the trench, such as at the corners of trench.

During the plasma etch step, the chamber pressure can be in the range of about 2 mTorr (0.267 Pa) to about 20 mTorr (2.67 Pa), preferably about 10 mTorr (1.33 Pa). During the plasma etch step, the plasma source power can be in the range of about 800 W to about 2500 W, optionally about 2200 W. During the plasma etch step, the bias power applied to the substrate can be a RF bias power. RF frequencies for the RF bias power can be between about 2 MHz and about 13.56 MHz. Typically, the platen 22 temperature setpoint is between about 10 °C and about 30 °C, preferably about 20 °C, whilst the chamber walls are cooled to a temperature of about 55 °C using water. A platen temperature of around 20 °C and a chamber wall temperature of about 55 °C is used due to the presence of chlorine in the etch gas mixture.

The plasma etch step results in the formation of a trench 34b. The trench 34b comprises a base 36b that is approximately parallel to the surface of the substrate 30 on which the mask 32 is formed. The trench 34b further comprises an opening 40b adjacent to the surface of the substrate 30 on which the mask 32 is formed.

The trench 34b further comprises sidewalls 38b between the base 36b and the opening 40b of the trench 34b. Preferably, the sidewalls 38b have a taper of between about 87 ° and about 90 ° to the plane perpendicular to the direction of anisotropic etching.

The duration of the plasma etch step depends on the thickness of the substrate 30 and the desired dimensions of the trench 34b in a manner known in the art.

The resultant substrate 30b comprises a fully formed feature 34b which has an opening 40b and a substantially flat base 36b as shown in Figure 1B. The sidewalls 38b can be formed to the desired taper angle.

The trench 34b can be subjected to a number of post-processing steps, such as mask removal, smoothing or polishing to provide the final feature.

### Example 1

An exemplary set of process parameters for the plasma etch step of the method of the first embodiment is shown in Table 1. The exemplary process was performed in the Omega^{™} Synapse^{™} etch apparatus at a temperature of 20 °C with source and bias RF power supplies, when used, operating at 13.56 MHz.

**Table 1**

| Process Parameter | |
|---|---|
| Pressure (mTorr) | 12 |
| Platen Back-Side Pressure of Helium (Torr) | 10 |
| ICP Source Power (Watts) | 2200 |
| Platen power (Watts) | 1300 |
| SF₆ flow (sccm) | 51 |
| Cl₂ flow (sccm) | 38 |
| SiF₄ flow (sccm) | 30 |
| SiCl₄ flow (sccm) | 68 |
| Ar flow (sccm) | 380 |
| O₂ flow (sccm) | 72 |

A trench etched by a plasma generated with the above parameters had a profile angle of 88.5°. While keeping all other parameters used in the example process in table 1 constant, lowering the SiCl₄ flow to 0 sccm and raising the SiF₄ flow to 98 sccm (i.e. raising the F:Cl ratio) changed the profile angle from 88.5° to 88.9°. Conversely, changing the flow (from that in table 1) to 90 sccm SiCl₄ and 20 sccm SiF₄ (i.e. lowering the F:Cl ratio), changed the profile angle from 88.5° to 87.6°. Most other etch characteristics, including the etch rate and selectivity for example, are not significantly altered by these process adjustments.

Structures formed using the exemplary process parameters above had uniform and smooth base and sidewalls that were acceptable for use as trenches.

Flat-based trenches etched using two different chemistry regimes, fluorinated and combined fluorinated and chlorinated chemistry were investigated. The results are summarised in Table 2.

**Table 2**

| Characteristic | Fluorinated Chemistry | Fluorinated and Chlorinated Chemistry |
|---|---|---|
| Profile angle (°) | 89.8 | 89.1 |
| Etch rate (nm/min) | 566 | 912 |
| Uniformity (+/-%) | 2.3 | 1.5 |
| Selectivity to SiO₂ mask material | 2.0:1 | 3.7:1 |

The fluorinated chemistry example shows a highly vertical profile angle with only moderate etch rate and has uniformity and selectivity towards the poor end of device manufacturer requirements. On the other hand, provided reasonable ratios of the gases are used, the combined fluorinated and chlorinated chemistry results in a desirable profile angle as standard and hence provides the opportunity to optimise other process characteristics. As shown in the table, combined fluorinated and chlorinated etch chemistry provides the highest etch rate and selectivity of the two chemistries, along with an excellent uniformity.

The method of the first embodiment of the present invention can provide smooth and uniform features formed in silicon carbide semiconductor in a flexible and simple process with finely tuned profile angles that does not sacrifice other etch characteristics such as selectivity and etch rate.

## Claims

1. A method of plasma etching a silicon carbide semiconductor substrate to form a feature, the method comprising the steps of:
• providing a substrate with a mask formed thereon on a substrate support in a chamber, the mask having an opening, wherein the substrate is formed from silicon carbide;
• performing a plasma etch step to anisotropically etch the substrate through the opening to produce a feature,
wherein the plasma etch step comprises generating a plasma from an etchant gas mixture comprising at least one fluorine-containing component and chlorine gas.

2. A method according to claim 1, wherein the at least one fluorine-containing component comprises SF₆, SiF₄ or a combination thereof, and optionally the flow rate of SF₆ is from 30 sccm to 60 sccm and/or the flow rate of SiF₄ is from 20 sccm to 98 sccm.

3. A method according to claim 2, wherein the at least one fluorine-containing component comprises both SF₆ and SiF₄.

4. A method according to any one of claims 1 to 3, wherein the etchant gas mixture further comprises SiCl₄ and optionally the flow rate of SiCl₄ is from 5 sccm to 95 sccm.

5. A method according to any one of claims 1 to 4, wherein the etchant gas mixture further comprises an oxygen-containing component, and wherein optionally the oxygen-containing component is O₂ gas.

6. A method according to any one of claims 1 to 5, wherein the flow rate of each of the at least one fluorine containing component, chlorine gas and, when present, SiCl₄ and the oxygen-containing component is at most 100 sccm.

7. A method according to claim 6 when dependent on claim 5, wherein the flow rate of the oxygen-containing component is from 5 sccm to 95 sccm, optionally from 50 sccm to 80 sccm.

8. A method according to claim 7, wherein the etchant gas mixture further comprises an inert gas component, and optionally the inert gas component is argon and/or the flow rate of the inert gas component is at most 500 sccm and further optionally the flow rate of the inert gas component is at least 300 sccm.

9. A method according to any one of claims 1 to 8, wherein the plasma etch step is performed using a plasma source that supplies a power of from 800 W to 2500 W to the plasma and/or an electrical power of from 700 W to 1400 W is applied to the substrate support during the plasma etch step.

10. A method according to claim any one of claims 1 to 9, wherein the substrate support is maintained at a temperature of between 10 °C and 30 °C, and optionally the substrate support is maintained at a temperature of about 20 °C.

11. A method according to any one of claims 1 to 10, wherein the pressure within the chamber is from 2 mTorr (0.267 Pa) to 20 mTorr (2.67 Pa).

12. A method according to any one of claims 1 to 11, wherein the chamber is cooled to a temperature of 55 °C.

13. A plasma etch apparatus for plasma etching a substrate to form a feature using the method according to any one of claims 1 to 12, the apparatus comprising:
• a chamber;
• a substrate support disposed within the chamber for supporting a substrate thereon;
• at least one gas inlet for introducing a gas or gas mixture into the chamber at a flow rate;
• a plasma generating means for sustaining a plasma in the chamber;
• a power supply for supplying an electrical bias power to the substrate support; and
• a controller configured to operate the plasma etch apparatus to generate a plasma from an etchant gas mixture comprising at least one fluorine-containing component and chlorine gas.

14. An apparatus according to claim 13, wherein the at least one gas inlet comprises a first gas inlet for introducing at least one fluorine-containing component into the chamber and a second gas inlet for introducing chlorine gas into the chamber, and the controller is configured to form an etchant gas mixture in the chamber comprising at least one fluorine-containing component and chlorine gas and generate a plasma from the etchant gas mixture, and wherein, optionally, the at least one gas inlet comprises a third gas inlet for introducing SiF₄ intro the chamber and a fourth gas inlet for introducing SiCl₄ into the chamber, and the controller is configured to form an etchant gas mixture in the chamber comprising the at least one fluorine-containing component that can comprise SiF₄, chlorine gas and SiCl₄ and generate a plasma from the etchant gas mixture.

15. An apparatus according to claim 13 or claim 14, wherein the at least one gas inlet comprises a fifth gas inlet for introducing an oxygen-containing component intro the chamber and a sixth gas inlet for introducing an inert gas component into the chamber, and the controller is configured to form an etchant gas mixture in the chamber comprising the at least one fluorine-containing component, chlorine gas, the oxygen-containing component and the inert gas component and generate a plasma from the etchant gas mixture.
